# EUROPEAN PATENT APPLICATION

(11) **EP 4 796 936 A1**
(43) Date of publication of application: **26.08.2026**
(21) Application number: 26156857.0
(22) Date of filing: 06.02.2026
(51) Int. Cl.: G01R 19/165

(54) **VOLTAGE COMPARISON CIRCUIT, RELATED INTEGRATED CIRCUIT AND METHOD**

(30) Priority: 24.02.2025 IT 202500003537
(71) Applicant: STMicroelectronics International N.V., 1228 Plan-les-Ouates, Geneva (CH)
(72) Inventor: SAVADKOUHI, Mahmoud, 81735 Munich (DE); SCHIAPPELLI, Fulvio, 81479 Munich (DE)
(74) Representative: Buzzi, Notaro & Antonielli d'Oulx S.p.A.

(57) **Abstract**

A voltage comparison circuit (20, 30) is disclosed. A measurement circuit (20) is configured to generate a measurement signal (*V_{S}*) indicative of an input voltage (*V_{IN}*), wherein the measurement circuit (20) comprises a voltage divider (RA, RB). The collectors of a first npn bipolar transistor (Q1) and a second npn bipolar transistor (Q2) are coupled to a supply voltage (*VDD*)*,* and the bases of the first npn bipolar transistor (Q1) and the second npn bipolar transistor (Q2) are coupled to an intermediate node (A) of the voltage divider (RA, RB). A first resistance (R1) is connected between the emitter of the first npn bipolar transistor (Q1) and ground (102), and a second resistance (R2) is connected between the emitter of the second npn bipolar transistor (Q2) and the emitter of the first npn bipolar transistor (Q1). An emitter area of the second bipolar transistor (Q2) is greater than an emitter area of the first bipolar transistor (Q1).

A comparison circuit (32, 34, 36, 40) is configured to generate a comparison signal (PG) as a function of a first current (*I_{Q1}*) flowing through the collector of the first npn bipolar transistor (Q1) and a second current (*I_{Q2}*) flowing through the collector of the second npn bipolar transistor (Q2). Specifically, in response to determining that the first current (*I_{Q1}*) is greater than the second current (*I_{Q2}*), the comparison circuit (32, 34, 36, 40) asserts the comparison signal (PG).

According to various embodiments, the voltage comparison circuit (20, 30) comprises an n-channel FET (M0) having a drain connected to the intermediate node (A), a source connected to the bases of the first npn bipolar transistor (Q1) and the second npn bipolar transistor (Q2) and a gate connected to a bias voltage (*V_{B}*), wherein the bias voltage (V_{B}) corresponds to or is smaller than the supply voltage *(VDD).*

## Description

### Technical field

The embodiments of the present description refer to a voltage comparison circuit.

### Description of the relevant art

In many applications it may be required to determine whether a voltage is greater than a given threshold value.

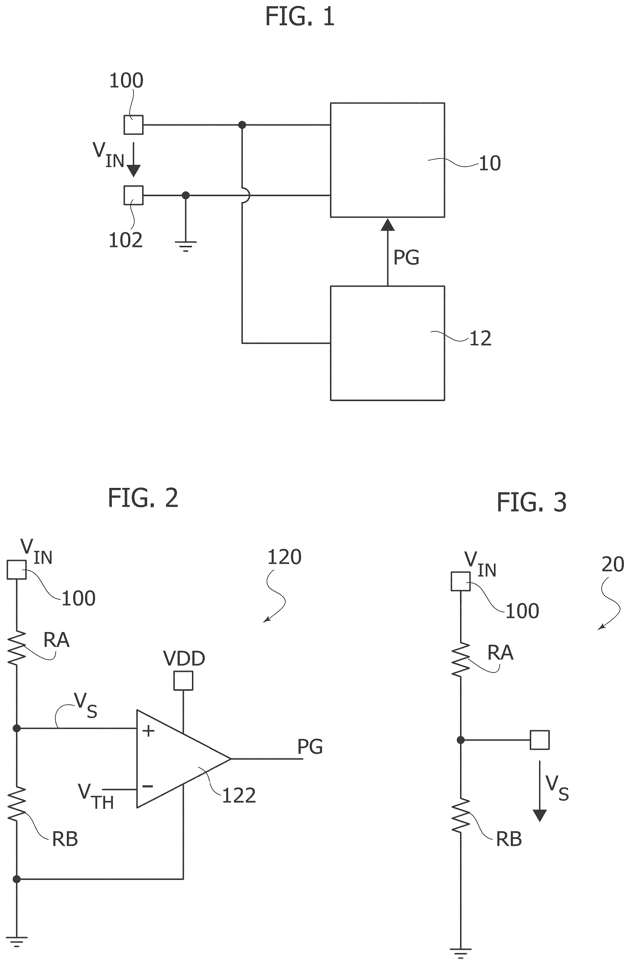

For example, Figure 1 shows a typical system, wherein a circuit 10 comprises two power supply terminals 100 and 102 configured to receive an input voltage *V_{IN}.* For example, the (negative) terminal 102 may represent ground GND. For example, the circuit 10 may implement a Power Management Unit (PMU). For example, the circuit 10 may implement one or more of the following functions: DC-to-DC conversion, battery charging, power-source selection, voltage scaling, etc.

In the example considered, the circuit 10 has associated a detection circuit 12 configured to monitor the input voltage *V_{IN}* and generate a signal PG indicating whether the input voltage *V_{IN}* is above a given threshold.

For example, Figure 2 shows an example of the detection circuit 12. Specifically, in the example considered, the detection circuit 12 comprises a measurement circuit 120 configured to generate a measurement signal *V_{S}* indicative of (e.g., proportional to) the voltage *V_{IN},* and a comparison circuit 122 configured to assert or de-assert a comparison signal PG as a function of the signal *V_{S}* and a threshold signal *V_{TH}.*

For example, in the example considered, the measurement circuit 120 comprises a voltage divider comprising two resistors RA and RB connected in series between the terminals 100 and 102, wherein the signal *V_{S}* corresponds to the voltage at the resistor RB.

In many applications, in order to indicate the logic level of the signal PG, the comparison signal PG is either set to 0 V (ground) or a voltage *VDD.* For example, this may be achieved by supplying the comparison circuit 122 with the voltage *VDD.* For example, such a detection circuit 12 is disclosed in Chinese Patent CN 101557215 B, which is incorporated herein by reference.

### Object and summary

Considering the foregoing, it is an object of various embodiments to provide improved solutions for voltage comparison circuits.

According to one or more embodiments, one or more of the above objects are achieved by a voltage comparison circuit having the distinctive elements set forth specifically in the ensuing claims. Embodiments moreover concern a related integrated circuit and method.

The scope of protection is defined in the appended claims, which form an integral part of the technical teaching of the description provided herein.

As mentioned before, various embodiments of the present disclosure relate to a voltage comparison circuit configured to assert a comparison signal in response to determining that an input voltage exceeds a given threshold voltage. The voltage comparison circuit comprises a first terminal and a second terminal configured to receive the input voltage, a further terminal configured to receive a supply voltage.

In various embodiments, a measurement circuit is configured to generate a measurement signal indicative of the input voltage. In various embodiments, the measurement circuit comprises a voltage divider connected between the first terminal and the second terminal, wherein an intermediate node of the voltage divider provides the measurement signal. In various embodiments, the voltage divider may comprise at least one switchable resistance in order to implement a voltage comparison circuit with hysteresis. For example, the switchable resistance may be switched as a function of the comparison signal.

In various embodiments, the voltage comparison circuit comprises also a first npn bipolar transistor and a second bipolar transistor, wherein the collectors of the first npn bipolar transistor and the second npn bipolar transistor are coupled to the further terminal configured to receive a supply voltage, and the bases of the first npn bipolar transistor and the second npn bipolar transistor are coupled to the intermediate node to receive the measurement signal. Specifically, the emitter area of the second bipolar transistor is greater than an emitter area of the first bipolar transistor. A first resistance is connected between the emitter of the first npn bipolar transistor and the second terminal, and a second resistance connected between the emitter of the second npn bipolar transistor and the emitter of the first npn bipolar transistor.

In various embodiments, a (current) comparison circuit is configured to generate the comparison signal as a function of a first current flowing through the collector of the first npn bipolar transistor and a second current flowing through the collector of the second npn bipolar transistor. Specifically, in various embodiments, the comparison circuit is configured to determine whether the first current is greater than the second current. In response to determining that the first current is greater than the second current, the comparison circuit asserts the comparison signal. Conversely, in response to determining that the first current is smaller than the second current, the comparison circuit de-assert the comparison signal.

According to a first aspect of the present disclosure, the voltage comparison circuit comprises also a voltage clamp comprising an n-channel FET having a drain connected to the intermediate node, a source connected to the bases of the first npn bipolar transistor and the second npn bipolar transistor and a gate connected to a bias voltage, wherein the bias voltage corresponds to or is smaller than the supply voltage.

According to a second aspect of the present disclosure, the (current) comparison circuit comprises a first current mirror, a second current mirror and a third current mirror. Specifically, the first current mirror has an input connected between the collector of the first npn bipolar transistor and the further terminal configured to receive a supply voltage, and the second current mirror has an input connected between the collector of the second npn bipolar transistor and the further terminal configured to receive a supply voltage. The third current mirror has an input connected in series with an output of the second current mirror and an output connected in series with an output of the first current mirror. Accordingly, the third current mirror essentially implements an active load. Accordingly, an analog comparator may be configured to assert the comparison signal in response to determining that a voltage at a further intermediate node between the output of the first current mirror and the third current mirror is greater than a further threshold. For example, the analog comparator may comprise an electronic switch having a current path connected with a third resistance between the further terminal configured to receive a supply voltage and the second terminal, wherein a control terminal of the electronic switch is connected to the further intermediate node. Specifically, in various embodiments, the electronic switch is a third n-channel FET having a source connected to the second terminal and a drain connected via the third resistance to the further terminal configured to receive a supply voltage, and wherein the analog comparator comprises an inverter configured to generate the comparison signal as a function of the drain-source voltage of the third n-channel FET.

For example, in various embodiments, the current mirrors are implemented with FETs. For example, the first current mirror may comprise a first p-channel FET having a source connected to the further terminal configured to receive a supply voltage, a drain connected to the collector of the first npn bipolar transistor, and a gate connected to the drain of the first p-channel FET, and a second p-channel FET having a source connected to the further terminal configured to receive a supply voltage, and a gate connected to the gate of the first p-channel FET. Similarly, the second current mirror may comprise a third p-channel FET having a source connected to the further terminal configured to receive a supply voltage, a drain connected to the collector of the second npn bipolar transistor, and a gate connected to the drain of the third p-channel FET, and a fourth p-channel FET having a source connected to the further terminal configured to receive a supply voltage and a gate connected to the gate of the third p-channel FET. In this case, the third current mirror may comprise a first n-channel FET having a source connected to the second terminal, a drain connected to a drain of the second p-channel FET corresponding to the further intermediate node, and a second n-channel FET having a source connected to the second terminal, a drain connected to a drain of the fourth p-channel FET, and a gate connected to a gate of the first n-channel FET and the drain of the second n-channel FET.

According to a third aspect of the present disclosure, the comparison circuit is configured to monitor the first current or the second current and determine whether the monitored current is smaller than a threshold, e.g., whether the monitored current is approximately zero. In response to determining that the monitored current is smaller than the threshold, the comparison circuit de-asserts the comparison signal. Conversely, in response to determining that the monitored current is greater than the threshold, the comparison circuit determines whether the first current is greater than the second current. In response to determining that the first current is greater than the second current, the comparison circuit asserts the comparison signal. Conversely, in response to determining that the first current is smaller than the second current, the comparison circuit de-asserts the comparison signal. Thus, in this case, the comparison circuit de-asserts the comparison signal when no current is flowing through the npn bipolar transistors, because the current comparison operation could not operate correctly. For example, the comparison circuit may comprise for this purpose a zero current detection circuit configured to monitor the first current or the second current and determine whether the monitored current is smaller than the threshold.

The various aspects disclosed herein may also be combined. For example, the voltage clamp may be used with the current mirror structure. Additionally or alternatively, when using the current mirror structure, the zero current detection circuit may sink a current from the further intermediate node in response to determining that the monitored current is smaller than the threshold. For example, in various embodiments, the zero current detection circuit comprises a transistor corresponding to a further output of the first current mirror or the second current mirror, and a circuit configured to sink the current from the further intermediate node, in response to determining that a current provided by the transistor is smaller than a given threshold. For example, in various embodiments, this circuit comprises a fourth current mirror having an input connected with a current bias source between the further terminal configured to receive a supply voltage and the second terminal, and a fifth current mirror having an input connected with an output of the fourth current mirror between the further terminal configured to receive a supply voltage and the second terminal, and an output connected to the further intermediate node. In this case, the zero current detection circuit may be configured to disable the fourth current mirror in response to determining that a current provided by the transistor is smaller than the given threshold.

For example, in various embodiments, the fourth current mirror comprises a seventh p-channel FET having a source connected to the further terminal configured to receive a supply voltage, a drain connected via the current bias source to the second terminal, and a gate connected to the drain of the seventh p-channel FET, and an eighth p-channel FET having a source connected to the further terminal configured to receive a supply voltage, and a gate connected to the gate of the seventh p-channel FET. Conversely, the fifth current mirror comprises a fourth n-channel FET having a source connected to the second terminal, a drain connected to a drain of the ninth p-channel FET, and a gate connected to the drain of the fourth n-channel FET, and a fifth n-channel FET having a source connected to the second terminal, a drain connected to the further intermediate node, and a gate connected to the gate of the fourth n-channel FET. In this case, the transistor may be a ninth p-channel FET having a source connected to the further terminal configured to receive a supply voltage and a drain connected to the gate of the seventh p-channel FET.

### Brief description of the annexed drawings

The embodiments of the present disclosure will now be described with reference to the annexed plates of drawings, which are provided purely to way of non-limiting example and in which:
The features and advantages of the present invention will become apparent from the following detailed description of practical embodiments thereof, shown by way of non-limiting example in the accompanying drawings, in which:
- Figure 1 shows a typical electronic system comprising a voltage comparison circuit
- Figure 2 shows an example of a voltage comparison circuit;
- Figure 3 shows an embodiment of a voltage measurement circuit;
- Figure 4 shows an embodiment of a voltage comparison circuit;
- Figure 5 shows waveforms of currents flowing in the voltage comparison circuit of Figure 4;
- Figures 6A, 6B, 6C and 7 show further embodiments of voltage measurement circuits;
- Figures 8 and 9 show further embodiments of voltage comparison circuits.

### Detailed description of embodiments

In the ensuing description, various specific details are illustrated aimed at enabling an in-depth understanding of the embodiments. The embodiments may be provided without one or more of the specific details, or with other methods, components, materials, etc. In other cases, known structures, materials, or operations are not shown or described in detail so that various aspects of the embodiments will not be obscured.

Reference to "an embodiment" or "one embodiment" in the framework of this description is meant to indicate that a particular configuration, structure, or characteristic described in relation to the embodiment is comprised in at least one embodiment. Hence, phrases such as "in an embodiment", "in one embodiment", or the like that may be present in various points of this description do not necessarily refer to one and the same embodiment. Moreover, particular conformations, structures, or characteristics may be combined in any adequate way in one or more embodiments.

The references used herein are only provided for convenience and hence do not define the sphere of protection or the scope of the embodiments.

In Figures 3 to 9 described below, parts, elements or components that have already been described with reference to Figures 1 and 2 are designated by the same references used previously in these figures. The description of these elements has already been made and will not be repeated in what follows in order not to burden the present detailed description.

As mentioned before, various embodiments of the present disclosure relate to a voltage comparison circuit configured to assert a comparison signal PG in response to determining that a voltage *V_{IN}* is greater than a given threshold.

Figure 3 shows an embodiment of a measurement circuit 20 configured to generate a signal *V_{S}* indicative of a voltage *V_{IN}.* For example, similar to the circuit shown in Figure 2, in the embodiment considered, the measurement circuit 20 comprises a voltage divider comprising (at least) a first resistance RA and a secondo resistance RB connected in series between the voltage *V_{IN}* and ground, wherein the measurement signal *V_{S}* corresponds to the voltage at the resistance RB. For example, in the embodiment considered, a first terminal of the resistance RA is connected to the terminal 100, a second terminal of the resistance RA is connected to a first terminal of the resistance RB, which represents an intermediate node A, and a second terminal of the resistance RB is connected to the terminal 102 (ground). Accordingly, in the embodiment considered, the measurement signal *V_{S}* corresponds to the voltage at the resistance RB, i.e., the voltage at the node A.

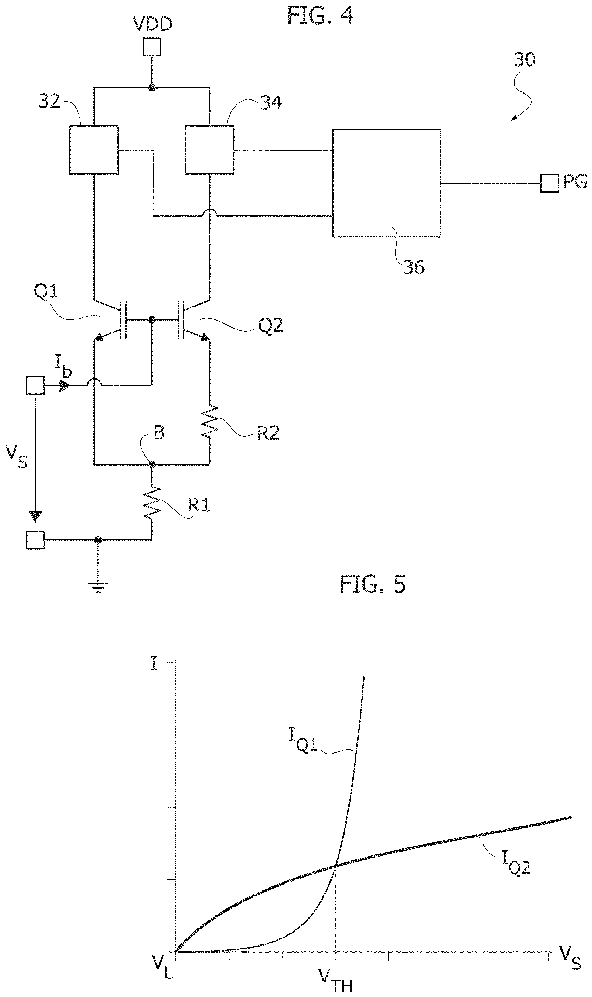

Figure 4 shows an embodiment of a comparison circuit 30. Substantially, in the embodiment considered, the comparison circuit 30 is implemented around a Brokaw bandgap reference. For example, in this context may be cited the article article by Paul Brokaw, "A Simple Three-Terminal IC Bandgap Reference," IEEE Journal of Solid-State Circuits, Vol. SC-9, No. 6, December 1974, PP 388-393, which is incorporated herein by reference.

Specifically, in the embodiment considered, the comparison circuit 30 comprises a first npn bipolar transistor Q1 and a second npn bipolar transistor Q2. In the embodiment considered, the emitter of the transistor Q1 is connected (e.g., directly) to a node B and the collector of the transistor Q1 is coupled to the supply voltage *VDD.* Moreover, in the embodiment considered, the emitter of the transistor Q2 is connected (e.g., directly) via a resistor R2 to the node B and the collector of the transistor Q2 is coupled to the supply voltage *VDD.* In the embodiment considered, the node B is connected (e.g., directly) via a resistor R1 to the terminal 102 (ground). Specifically, as will be better explained in the following, the term "coupled" does not imply that the collector terminals are connected directly to the voltage *VDD.*

Specifically, in the embodiment considered, the base terminal of the transistor Q1 is connected (e.g., directly) to the base terminal of the transistor Q2, wherein the base terminals receive the measurement voltage *V_{S}.* For example, the base terminals of the transistors Q1 and Q2 may be connected to the node A of the measurement circuit 20 shown in Figure 3.

Specifically, in various embodiments, the emitter area of the transistor Q2 is *N* times larger than the emitter area of the transistor Q1. For example, in various embodiments N is greater than four. Thus, the larger transistor Q2 will achieve a given current at a lower base-emitter voltage *V_{BE}* than the smaller transistor Q1. Accordingly, since the transistor Q2 has an emitter area that is N times larger than the emitter area of the transistor Q1, the base-emitter voltage *V_{BE2}* of the transistor Q2 will be lower than the base-emitter voltage *V_{BE1}* of the transistor Q1 by a magnitude of: $Δ {V}_{BE} = {V}_{T} ln \left(N\right)$ where *V_{T}* corresponds to the thermal voltage (*kT*/*q*). For example, in various embodiments, *N* corresponds to eight, because the term ln (*N*) is approximately 2.

Specifically, as shown in Figure 5, once the voltage *V_{S}* exceeds a given lower value *V_{L},* the transistors Q1 and Q2 are conductive. Specifically, when the voltage *V_{S}* is smaller than a threshold voltage *V_{TH},* the current *I_{Q1}* flowing through the transistor Q1 is smaller than the current *I_{Q2}* flowing through the transistor Q2 (due to the lower base-emitter voltage). Conversely, when the voltage *V_{S}* is greater than the threshold voltage *V_{TH},* the current *I_{Q1}* flowing through the transistor Q1 is greater than the current *I_{Q2}* flowing through the transistor Q2.

Specifically, the threshold voltage *V_{TH}* corresponds to the point where the currents *I_{Q1}* and *Ig₂* correspond, i.e., *I_{Q1}* = *I_{Q2}.* In this situation, the voltage difference *ΔV_{BE}* is applied to the resistor R2, and the resistor R1 is transversed by a current corresponding to 2 *·I_{Q2},* i.e. the following voltage *V₁* is generated at the resistor R1: ${V}_{1} = 2 \frac{R 1}{R 2} {V}_{T} ln \left(N\right)$

Thus, the threshold voltage *V_{TH}* corresponds to sum of the voltage drop *V₁* and the base-emitter voltage *V_{BE1}* of the transistor Q1, i.e.: ${V}_{TH} = {V}_{1} + {V}_{BE 1} = 2 \frac{R 1}{R 2} {V}_{T} ln \left(N\right) + {V}_{BE 1}$

Specifically, according to a Brokaw bandgap reference, the threshold *V_{TH}* is substantially constant over temperature.

Accordingly, by also taking into account the voltage divider RA and RB, the threshold voltage *V_{IN_TH}* for the input voltage *V_{IN}* may be calculated as: ${V}_{IN _ TH} = \left(1+\frac{RA}{RB}\right) {V}_{TH} = \left(1+\frac{RA}{RB}\right) \left(2\frac{R 1}{R 2}{V}_{T}ln\left(N\right)+{V}_{BE 1}\right)$

Accordingly, in the embodiments considered, the circuit is configured to compare the collector current *I_{Q1}* of the transistor Q1 with the collector current *I_{Q2}* of the transistor Q2. For example, in the embodiment considered, the collector of the transistor Q1 is connected (e.g., directly) via a first current measurement circuit 32 to the voltage *VDD,* and the collector of the transistor Q2 is connected (e.g., directly) via a second current measurement circuit 34 to the voltage *VDD.* Moreover, a comparison circuit 36 is configured to generate the signal PG as a function of the signals provided by the current measurement circuits 32 and 34.

Accordingly, in the embodiment considered, the measurement voltage *V_{S}* is applied directly to the base terminals of the transistors Q1 and Q2. Specifically, the use of the voltage divider RA and RB within the measurement circuit 20 permits to monitor also voltages *V_{IN},* which are greater than the voltage *VDD.* Accordingly, the comparison circuit 30 may be in a low-voltage domain. For example, the voltage *VDD* may be selected in a range between 1 and 5 V, e.g., between 2.5 and 3 V, and the voltage *V_{IN}* (when supplied to the terminals 100 and 102) may be greater than the voltage *VDD,* e.g., the voltage *V_{IN}* may be greater than 5 V, e.g., between 9 V and 24 V. A low-voltage comparison circuit 30 has also several advantages. First of all, the comparison circuit 30 already provides a binary comparison signal PG in the low-voltage domain usually used by other digital processing circuits, e.g., within the circuit 10, thereby avoiding an additional level shifter circuit. Moreover, low-voltage components, such as low-voltage transistors and resistances, usually have a better matching and accuracy, e.g., in terms of process, voltage and temperature (PVT) variations. Furthermore, the area of low-voltage components is usually smaller than respective high-voltage one.

However, in case the input voltage *V_{IN}* may assume different values, the measurement voltage *V_{S}* may also exceed the voltage *VDD,* and potentially damage the circuit 30. Thus, the measurement voltage *V_{S}* should be limited to a maximum value being at most *VDD.* For example, this may be obtained by limiting the voltage *V_{S}* via a Zener diode. However, such a Zener diode will generate electric losses based on the value of the current flowing through the resistance RA. Thus, in order to reduce the power consumption of the detection circuit 20, the resistances RA and RB should be large.

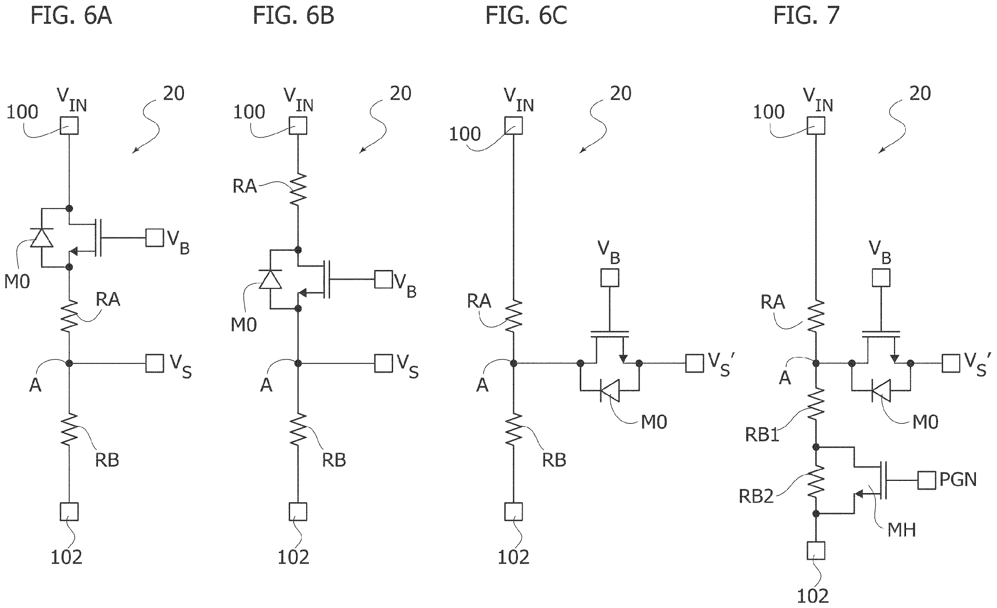

Figures 6A, 6B and 6C show alternative embodiments of measurement circuits 20. Specifically, in the embodiment considered, the measurement circuit 20 comprises now a clamping circuit implemented with a n-channel Field-Effect Transistor (FET) M0.

Specifically, in the embodiment shown in Figure 6A, (the current path of) the FET M0 is connected (e.g., directly) between the resistance RA and the terminal 100 configured to receive the voltage *V_{IN}.* Specifically, in the embodiment considered, the drain terminal of the FET M0 is connected (e.g., directly) to the terminal 100, and the source terminal of the FET M0 is connected (e.g., directly) via the voltage divider RA and RB to ground, i.e., the terminal 102. Specifically, in the embodiment considered, a first terminal of the resistance RA is connected to the source terminal of the FET M0, a second terminal of the resistance RA is connected to a first terminal of the resistance RB and a second terminal of the resistance RB is connected to the terminal 102, wherein the intermediate node A between the resistances RA and RB is connected to the base terminals of the transistors Q1 and Q2.

Specifically, in various embodiments, the gate terminal of the FET M0 is connected to a bias voltage *V_{B}* indicative of a maximum value to which the voltage at the source terminal of the FET M0 should be limited. For example, in the embodiment considered, the gate terminal is connected (e.g., directly) to the voltage *VDD,* i.e. *V_{B}* = *VDD.* However, in various embodiments, the bias voltage *V_{B}* may also be smaller than the supply voltage *VDD.* Accordingly, in the embodiment considered, the clamping FET M0 limits the voltage at the voltage divider RA, RB.

Conversely, Figure 6B shows an embodiment, wherein (the current path of) the FET M0 is connected (e.g., directly) between the resistance RA and the node A. Specifically, in the embodiment considered, the drain terminal of the FET M0 is connected (e.g., directly) via the resistance RA to the terminal 100, and the source terminal of the FET M0 is connected (e.g., directly) via the resistance RB to the terminal 102. Accordingly, in the embodiment considered, the node A corresponds to the source terminal of the FET M0. Also in this case, the gate terminal of the FET M0 is connected to a bias voltage *V_{B},* e.g., the voltage *VDD.* Accordingly, in the embodiment considered, the clamping FET M0 limits the voltage at the resistance RB.

Finally, Figure 6C shows an embodiment, wherein (the current path of) the FET M0 is connected (e.g., directly) between the node A and the base terminals of the transistors Q1 and Q2. Specifically, in the embodiment considered, the terminal 102 is connected via the resistances RA and RB to the terminal 102 (ground). Moreover, the drain terminal of the FET M0 is connected (e.g., directly) to the node A (intermediate node between the resistances RA and RB), and the source terminal of the FET M0 is connected (e.g., directly) to the base terminals of the transistors Q1 and Q2. Also in this case, the gate terminal of the FET M0 is connected to a bias voltage *V_{B},* e.g., the voltage *VDD.* Accordingly, in the embodiment considered, the clamping FET M0 generates at the base terminals of the transistors Q1 and Q2 a limited voltage *V_{S}'.* Accordingly, the embodiment shown in Figure 6C provides an isolation between the measurement circuit 20 and the comparison circuit 30, which prevents direct interaction between these two domains, which could otherwise lead to circuit instability or damage.

Figure 7 shows a further embodiment of a measurement circuit 20, wherein the resistance RB is a switchable resistance RB. The switchable resistance RB may be used in any of the measurement circuits 20 show in Figures 3, 6A, 6B and 6C.

Specifically, in the embodiment considered, the resistance RB comprises two resistances RB1 and RB2 connected in series. Moreover, an electronic switch MH is configured to selectively short-circuit the resistance RB2. For example, in the embodiment considered, the resistance RB2 is connected to ground. For example, the electronic switch MH may be an n-channel FET. For example, in the embodiment considered, the source terminal of the FET MH is connected to ground and the drain terminal of the FET MH is connected to the intermediate node between the resistances RB1 and RB2.

Accordingly, when the electronic switch MH is closed, the voltage comparison circuit has the following (rising) threshold for the input voltage *V_{IN}:* ${V}_{IN _ TH _ H} = \left(1+\frac{RA}{RB 1}\right) \left(2\frac{R 1}{R 2}{V}_{T}ln\left(N\right)+{V}_{BE 1}\right)$

Conversely, when the electronic switch MH is opened, the voltage comparison circuit has the following (falling) threshold for the input voltage *V_{IN}:* ${V}_{IN _ TH _ L} = \left(1+\frac{RA}{RB 1 + RB 2}\right) \left(2\frac{R 1}{R 2}{V}_{T}ln\left(N\right)+{V}_{BE 1}\right)$

Accordingly, the switchable resistance RB may be used to implement a voltage comparison circuit configured as a comparator with hysteresis. Specifically, in this case, the electronic switch MH may initially be closed, thereby setting the threshold voltage *V_{TH}* to the voltage *V_{IN_TH_H}.* Next, once the comparison signal PG is asserted, the electronic switch MH is opened, thereby setting the threshold voltage *V_{TH}* to the threshold voltage *V_{IN_TH_L}.* Accordingly, in various embodiment, the electronic switch MH may be configured to short-circuit the resistance RB2 in response to determining that the signal PG is low/de-asserted. For example, in the embodiment considered, the gate terminal of the FET MH receives an inverted version PGN of the signal PG.

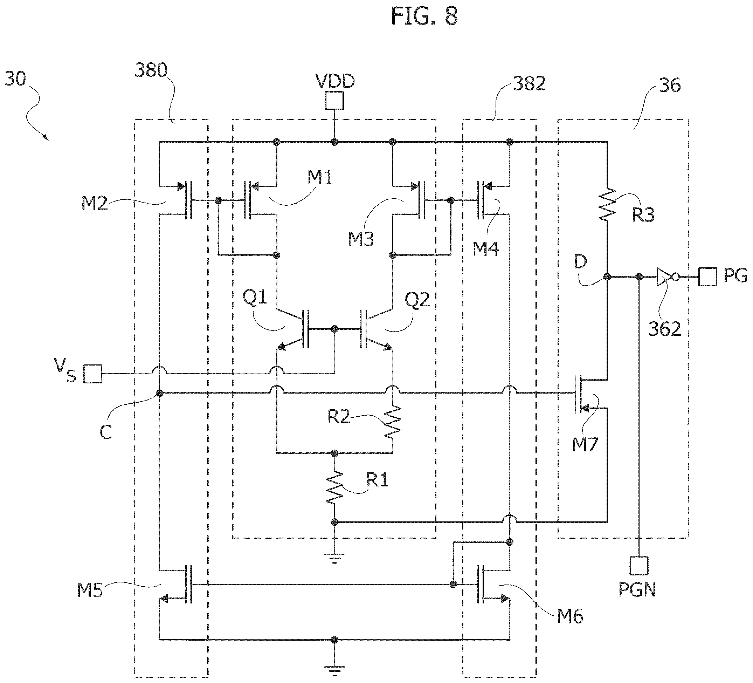

Figure 8 shows an embodiment of a comparison circuit 30 according to the present disclosure. Specifically, in the embodiment considered, the comparison circuit comprises again the transistors Q1 and Q2, and the resistances R1 and R2. Reference is made to the description of Figure 4 for a description of these components. As mentioned before, the base terminals of the transistors Q1 and Q2 is connected to a voltage *V_{S}* (or *V'_{S})* provided by any of the previously described measurement circuits 20, which may include the clamping FET M0 (Figures 6A, 6B and 6C) and/or the switchable resistance RB (Figure 7).

Accordingly, in the embodiment considered, the comparison circuit 30 is configured to compare the current *I_{Q1}* flowing through the collector of the transistor Q1 with the current *I_{Q2}* flowing through the collector of the transistor Q2.

Specifically, in the embodiment considered, a first current mirror (comprising two transistors M1 and M2) is configured to generate a copy of the current *I_{Q1}.* Specifically, in the embodiment considered, the transistors M1 and M2 are p-channel FETs. For example, in the embodiment considered, the collector of the transistor Q1 is connected (e.g., directly) to the drain of the FET M1, the source terminals of the FETs M1 and M2 are connected (e.g., directly) to the terminal 100/the supply voltage *VDD,* and the gate terminal of the FET M2 is connected (e.g., directly) to the gate terminal of the FET M1, which is connected to the drain terminal of the FET M1. Accordingly, in the embodiment considered, the output of the current mirror M1/M2, indicated in the following also as node C, e.g., the drain terminal of the FET M2, provides a current being proportional to the current *I_{Q1}* (based on the scaling between the transistors M1 and M2, which may also have the same dimension).

Similarly, in the embodiment considered, a second current mirror (comprising two transistors M3 and M4) is configured to generate a copy of the current *I_{Q2}.* Specifically, in the embodiment considered, the transistors M3 and M4 are p-channel FETs. For example, in the embodiment considered, the collector of the transistor Q2 is connected (e.g., directly) to the drain of the FET M3, the source terminals of the FETs M3 and M4 are connected (e.g., directly) to the terminal 100/the supply voltage *VDD,* and the gate terminal of the FET M4 is connected (e.g., directly) to the gate terminal of the FET M3, which is connected to the drain terminal of the FET M3. Accordingly, in the embodiment considered, the output of the current mirror M3/M4, e.g., the drain terminal of the FET M4, provides a current being proportional to the current *I_{Q2}* (based on the scaling between the transistors M3 and M4, which may also have the same dimension).

In the embodiment considered, the comparison circuit 30 comprises also a circuit configured to compare the current provided by the current mirror M1/M2 with the current provided by the current mirror M3/M4. Specifically, in the embodiment considered, the comparison is implemented with an active load configured to sense the currents provided by the transistors M2 and M4. Specifically, in the embodiment considered, the circuit 32 comprises n-channel FET M5, wherein the source terminal of the FET M5 is connected (e.g., directly) to the terminal 102/ground, and the drain terminal of the FET M5 is connected (e.g., directly) to the output of the current mirror M1/M2, i.e. the node C, e.g., the drain terminal of the FET M2. Similarly, in the embodiment considered, the circuit 34 comprises n-channel FET M6, wherein the source terminal of the FET M6 is connected (e.g., directly) to the terminal 102/ground, and the drain terminal of the FET is connected (e.g., directly) to the output of the current mirror M3/M4, e.g., the drain terminal of the FET M4. Specifically, in the embodiment considered, the gate terminal of the FET M5 is connected to the gate terminal of the FET M6, which is connected (e.g., directly) to the drain terminal of the FET M6. Accordingly, in the embodiment considered, the FETs M5 and M6 implement essentially a current mirror.

Accordingly, in the embodiment considered, the current measurement circuits 32 and 34 are implemented with two branches 380 and 382, wherein the branch 382 comprises the output of the current mirror M3/M4, and the input of the current mirror M5/M6, and the branch 380 comprises the output of the current mirror M1/M2, and the output of the current mirror M5/M6.

Thus, once the current *I_{Q1}* exceeds the current *I_{Q2},* the voltage at the node C increases. Accordingly, in the embodiment considered, the comparison circuit 36 is configured to assert the comparison signal PG as a function of the voltage at the node C, i.e., assert the signal PG in response to determining that the voltage at the node C exceeds a threshold value.

For example, in the embodiment considered, the comparison circuit 36 comprises an electronic switch M7 configured to selectively connect a node D to ground as a function of the voltage at the node C. For example, in the embodiment considered, the electronic switch M7 is an n-channel FET having a source terminal connected (e.g., directly) to the terminal 102/ground, a drain terminal connected to the node D and a gate terminal connected to the node C, whereby the electronic switch M7 is closed when the current *I_{Q1}* exceeds the current *I_{Q2}.* In various embodiments, the node D is connected via a pull-down resistance R3 to the terminal 100/the supply voltage *VDD.*

Accordingly, in the embodiment considered, the voltage at the node D is low when the current *I_{Q1}* exceeds the current *I_{Q2}.* Accordingly, in the embodiment considered, an inverter 362 (supplied by the voltage *VDD*) may be used to generate the signal PG as a function of the voltage at the node D, which may correspond to the signal PGN.

The comparison circuit 30 described in the foregoing have the disadvantage, that the comparison circuit 30 only works correctly once the voltage *V_{S}* exceeds the lower voltage *V_{L}.* In fact, at lower voltages, the current *I_{Q1}* and *I_{Q2}* are zero.

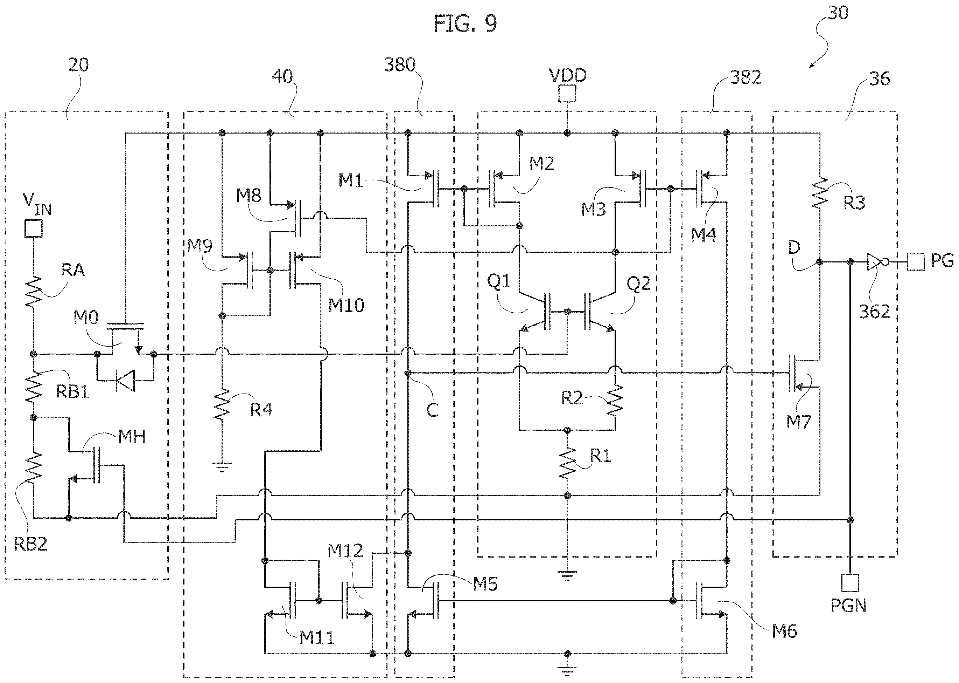

Figure 9 shows an embodiment of a voltage comparison circuit, which is configured to determine whether the current *I_{Q1}* and/or *I_{Q2}* is zero and de-assert the signal PG in response to determining that the current *I_{Q1}* and/or *I_{Q2}* is zero.

Specifically, in the embodiment considered, the voltage comparison circuit comprises again a measurement circuit 20 configured to generate a signal *V_{S}* (or *V_{S}*') indicative of the voltage *V_{IN}.* Reference is made to the description of Figures 3, 6A, 6B, 6C and 7 for possible embodiments of the measurement circuit 20. For example, in the embodiment considered, the measurement circuit 20 comprises a voltage divider having resistances RA and RB, wherein the resistance RB is a switchable resistance, e.g., implemented with two resistances RB 1 and RB2 and an electronic switch MH. Moreover, in the embodiment considered, the measurement circuit 20 comprises a clamping FET; such as an n-channel FET connected between the node A of the voltage divider and the base terminals of the transistors Q1 and Q2.

In the embodiment considered, the voltage comparison circuit comprises thus also a comparison circuit 30 configured to assert the comparison signal PG in response to determining that the current *I_{Q1}* is greater than the current *I_{Q2}.* For example, in the embodiment considered, the comparison circuit 30 has the architecture described with respect to Figure 8.

Specifically, in the embodiment considered, the comparison circuit 30 comprises now also a zero current detection circuit 40. Specifically, in the embodiment considered, the zero current detection circuit 40 is configured to monitor either the current *I_{Q1}* or the current *I_{Q2},* and determine whether the monitored current is lower than a threshold value. Moreover, in response to determining that the monitored current is lower than a threshold value, the zero current detection circuit 40 de-asserts the comparison signal PG. Conversely, when the monitored current is greater than a threshold value, the comparison circuit 30 operates as described in the foregoing, i.e., the comparison circuit 30 is configured to assert the comparison signal PG in response to determining that the current *I_{Q1}* is greater than the current *I_{Q2}* and de-assert the comparison signal PG in response to determining that the current *I_{Q1}* is smaller than the current *I_{Q2}.*

Specifically, in the embodiment considered, the zero current detection circuit 40 comprises a resistance R4 connected between the terminals 100 and 102, i.e., between the supply voltage VDD and ground. Moreover, the input of a current mirror M9/M10 is connected in series with the resistance R4. For example, in the embodiment considered, the current mirror is implemented with two p-channel FETs M9 and M10, wherein the source terminals of the FETs M9 and M10 are connected to the terminal 100/the supply voltage VDD, the drain terminal of the FET M9 is connected via the resistance R4 to the terminal 102/ground and the gate terminal of the FET M10 is connected to the gate terminal of the FET M9, which is connected to the drain terminal of the FET M9. In various embodiments, the resistance R4 may be replaced with other bias current sources.

Moreover, in the embodiment considered, the gate terminals of the FETs M9 and M10 are connected via a p-channel FET M8 to the terminal 100/the supply voltage VDD, wherein the gate terminal of the FET M8 is connected to the gate terminal of the FET M3. Accordingly, in the embodiment considered, the FET M8 implements a further output stage of the current mirror M3/M4, and thus provides a current being proportional to the current *I_{Q2}.* Similarly, the FET M8 may implement a further output stage of the current mirror M1 /M2, and provide a current being proportional to the current *I_{Q1}.* For example, in this case, the gate terminal of the FET M8 may be connected to the gate terminal of the FET M1.

Accordingly, when the output stage M8 of the current mirror M3/M4 (or similarly M1/M2) does not provide a current, the output stage M10 of the current mirror M9/M10 provides a current being proportional to the bias current, e.g., the current flowing through the resistance R4. Accordingly, in this condition the signal PG should be de-asserted. For example, in the embodiment considered, the zero current detection circuit 40 is configured to pull the node C to ground in response to determining that the output stage M10 of the current mirror M9/M10 provides a current, i.e., the zero current detection circuit 40 forces the value of signal PG to a reset value of 0.

For example, in the embodiment considered, the zero current detection circuit 40 comprises a further current mirror M11/M12, wherein the input stage M11 of the current mirror M11/M12 receives the current provided by the output stage M10 of the current mirror M9/M10 and the output stage M12 of the current mirror M11/M12 sinks a proportional current from the node C. For example, in the embodiment considered, the current mirror M11/M12 is implemented with n-channel FETs, wherein the source terminals of the FETs M11 and M12 are connected to the terminal 102/ground, the drain terminal of the FET M11 is connected to the output stage of the current mirror M9/M10, e.g., the drain terminal of the FET M10, the drain terminal of the FET M12 is connected to the node C, and the gate terminal of the FET M12 is connected to the gate terminal of the FET M11, which is connected to the drain terminal of the FET M11.

Conversely, when the current provided by the transistor M8 is greater than zero, the current mirror M9/M10 is disabled, whereby the current mirror M11/M12 stops to sink current from the node C, i.e., the zero current detection circuit 40 is disabled.

Accordingly, in the embodiment considered, the comparison signal PG is valid over the complete operating range of the input voltage *V_{IN}.* For example, in the embodiment considered, the zero current detection circuit 40 is configured to ensure that the node C is not floating when the signal *V_{S}* is smaller than the voltage *V_{L}.*

Accordingly, the solutions disclosed herein incorporate a self-biased high-voltage input comparator that operates with a single stable state. This self-biasing mechanism eliminates the requirement for external start-up circuitry, which is typically used in conventional designs to ensure proper initialization of the circuit. By relying on an inherent stable operating point, the circuit simplifies the design and reduces power consumption. The absence of start-up circuitry enhances reliability by removing potential points of failure and enables seamless operation even under fluctuating input voltage conditions.

The design intentionally avoids the use of feedback regulation loops, which are often employed to stabilize circuits but can introduce undesirable effects such as delays, oscillations, or instability under certain conditions. Without these loops, the circuit achieves unconditional stability, operating reliably across a wide range of input and environmental conditions. This absence of regulation loops also reduces complexity and enhances the circuit's responsiveness, making it more robust for high-voltage applications where stability is critical.

In various embodiments, the n-channel transistor M0 permits to isolate the input voltage domain *V_{IN}* from the supply voltage domain *VDD.* In various embodiments, as shown in Figure 6C, the transistor M0 is interposed between the voltage divider RA/RB and the comparison circuit 30. This isolation prevents direct interaction between these two domains, which could otherwise lead to circuit instability or damage. Specifically, the transistor M0 clamps the base voltage of the bipolar transistors Q1 and Q2 below the voltage *VDD,* ensuring that the collectorbase (C-B) junctions of these transistors remain reverse-biased. This prevents forward biasing of the C-B junctions, which could create unintended current paths and compromise the circuit's performance, particularly in high-voltage scenarios.

In various embodiments, the comparison circuit 30 employs a mirror structure that (together with the transistor M0) permits to address the issue of parasitic PNP transistors turning on within the circuit. Parasitic pnp transistors, so called B-C-SUB pnp transistors, can form unintentionally in semiconductor designs between the base and collector terminals and the substrate, which acts as an emitter terminal. Such parasitic pnp transistors may activate due to voltage differences across the base, collector, and substrate junctions. Such activation leads to current injection into the substrate, increasing the circuit's quiescent current and the risk of latch-up. Latch-up is a potentially destructive condition where unintended conductive paths form, causing excessive current draw and possible circuit failure.

Of course, without prejudice to the principle of the invention, the details of construction and the embodiments may vary widely with respect to what has been described and illustrated herein purely by way of example, without thereby departing from the scope of the present invention, as defined by the ensuing claims.

For example, while the current mirrors described in the foregoing use FETs, the current mirrors may also use bipolar transistors. For example, p-channel FETs may be replaced with pnp bipolar transistors. Similarly, n-channel FETs may be replaced with npn bipolar transistors. For example, in this case, the source terminal of a FET is replaced with the emitter terminal of a respective bipolar transistor, the drain terminal of a FET is replaced with the collector terminal of a respective bipolar transistor, and the gate terminal of a FET is replaced with the base terminal of a respective bipolar transistor.

Additionally or alternatively, the various resistances shown in the Figures may be implemented with discrete resistors or via resistances implemented in the integrated circuit of the detection circuit, such as tracks having given lengths or by replacing the resistances with suitably biased FETs.,

## Claims

1. A voltage comparison circuit (20, 30) configured to assert a comparison signal (PG) in response to determining that an input voltage (V_{IN}) exceeds a given threshold voltage, wherein the voltage comparison circuit comprises:
- a first terminal (100) and a second terminal (102) configured to receive said input voltage (*V_{IN}*);
- a further terminal configured to receive a supply voltage (*VDD*);
- a measurement circuit (20) configured to generate a measurement signal (*V_{S}*) indicative of said input voltage (*V_{IN}*), wherein said measurement circuit (20) comprises a voltage divider (RA, RB) connected between said first terminal (100) and said second terminal (102), wherein an intermediate node (A) of said voltage divider (RA, RB) provides said measurement signal (*V_{S}*);
- a first npn bipolar transistor (Q1) and a second bipolar transistor (Q2), each having a collector, an emitter, and a base, wherein the collectors of said first npn bipolar transistor (Q1) and said second npn bipolar transistor (Q2) are coupled to said further terminal configured to receive a supply voltage *(VDD),* and the bases of said first npn bipolar transistor (Q1) and said second npn bipolar transistor (Q2) are coupled to said intermediate node (A) to receive said measurement signal *(V_{S}; V_{S}*'), wherein an emitter area of said second bipolar transistor (Q2) is greater than an emitter area of said first bipolar transistor (Q1);
- a first resistance (R1) connected between the emitter of said first npn bipolar transistor (Q1) and said second terminal (102), and a second resistance (R2) connected between the emitter of said second npn bipolar transistor (Q2) and the emitter of said first npn bipolar transistor (Q1); and
- a voltage clamp comprising an n-channel FET (M0) having a drain connected to said intermediate node (A), a source connected to the bases of said first npn bipolar transistor (Q1) and said second npn bipolar transistor (Q2) and a gate connected to a bias voltage *(V_{B}),* wherein said bias voltage (V_{B}) corresponds to or is smaller than said supply voltage (*VDD*);
- a comparison circuit (32, 34, 36, 40) configured to generate said comparison signal (PG) as a function of a first current (*I_{Q1}*) flowing through the collector of said first npn bipolar transistor (Q1) and a second current *(I_{Q2})* flowing through the collector of said second npn bipolar transistor (Q2); wherein said comparison circuit (32, 34, 36, 40) is configured to:
- determine whether said first current (*I_{Q1}*) is greater than said second current *(I_{Q2}),*
- in response to determining that said first current (*I_{Q1}*) is greater than said second current (*I_{Q2}*), assert said comparison signal (PG), and
- in response to determining that said first current (*I_{Q1}*) is smaller than said second current (*I_{Q2}*), de-assert said comparison signal (PG).

2. The voltage comparison circuit according to Claim 1, wherein said comparison circuit (32, 34, 36, 40) comprises:
- a first current mirror (M1, M2) having an input connected between the collector of said first npn bipolar transistor (Q1) and said further terminal configured to receive a supply voltage *(VDD),*
- a second current mirror (M3, M4) having an input connected between the collector of said second npn bipolar transistor (Q2) and said further terminal configured to receive a supply voltage *(VDD),*
- a third current mirror (M5, M6) having an input connected in series with an output of said second current mirror (M3, M4) and an output connected in series with an output of said first current mirror (M1, M2),
- a comparator (36) configured to assert said comparison signal (PG) in response to determining that a voltage at a further intermediate node (C) between the output of said first current mirror (M1, M2) and said third current mirror (M5, M6) is greater than a further threshold.

3. The voltage comparison circuit according to Claim 2,
wherein said first current mirror (M1, M2) comprises:
- a first p-channel FET (M2) having a source connected to said further terminal configured to receive a supply voltage *(VDD),* a drain connected to the collector of said first npn bipolar transistor (Q1), and a gate connected to the drain of said first p-channel FET (M2);
- a second p-channel FET (M1) having a source connected to said further terminal configured to receive a supply voltage *(VDD),* and a gate connected to the gate of said first p-channel FET (M2);
wherein said second current mirror (M3, M4) comprises:
- a third p-channel FET (M3) having a source connected to said further terminal configured to receive a supply voltage *(VDD),* a drain connected to the collector of said second npn bipolar transistor (Q2), and a gate connected to the drain of said third p-channel FET (M3);
- a fourth p-channel FET (M4) having a source connected to said further terminal configured to receive a supply voltage *(VDD)* and a gate connected to the gate of said third p-channel FET (M3);
wherein said third current mirror (M5, M6) comprises:
- a first n-channel FET (M5) having a source connected to said second terminal (102), a drain connected to a drain of said second p-channel FET (M1) corresponding to said further intermediate node (C);
- a second n-channel FET (M6) having a source connected to said second terminal (102), a drain connected to a drain of said fourth p-channel FET (M4), and a gate connected to a gate of said first n-channel FET (M5) and the drain of said second n-channel FET (M6).

4. The voltage comparison circuit according to Claim 2 or Claim 3, wherein said comparator (36) comprises:
- an electronic switch (M7) having a current path connected with a third resistance (R3) between said further terminal configured to receive a supply voltage *(VDD)* and said second terminal (102), wherein a control terminal of said electronic switch (M7) is connected to said further intermediate node (C).

5. The voltage comparison circuit according to Claim 4, wherein said electronic switch (M7) is a third n-channel FET having a source connected to said second terminal (102) and a drain connected via said third resistance (R3) to said further terminal configured to receive a supply voltage *(VDD),* and wherein said comparator (36) comprises an inverter (362) configured to generate said comparison signal (PG) as a function of the drain-source voltage of said third n-channel FET (M7).

6. The voltage comparison circuit according to any of the previous claims, wherein said comparison circuit (32, 34, 36, 40) is configured to:
- monitor said first current (*I_{Q1}*) or said second current *(I_{Q2}),*
- determine whether said monitored current (*I_{Q1}*; *I_{Q2}*) is smaller than a threshold,
- in response to determining that said monitored current (*I_{Q1}*; *I_{Q2}*) is smaller than said threshold, de-assert said comparison signal (PG),
- in response to determining that said monitored current (*I_{Q1}*; *I_{Q2}*) is greater than said threshold:
- determine whether said first current (*I_{Q1}*) is greater than said second current (*I_{Q2}*),
- in response to determining that said first current (*I_{Q1}*) is greater than said second current (*I_{Q2}*), assert said comparison signal (PG), and
- in response to determining that said first current (*I_{Q1}*) is smaller than said second current (*I_{Q2}*), de-assert said comparison signal (PG).

7. The voltage comparison circuit according to a combination of Claims 2 and 6, wherein said comparison circuit (32, 34, 36, 40) comprises a zero current detection circuit (40) configured to:
- monitor said first current (*I_{Q1}*) or said second current *(I_{Q2}),*
- determine whether said monitored current (*I_{Q1}*; *I_{Q2}*) is smaller than said threshold,
- in response to determining that said monitored current (*I_{Q1}*; *I_{Q2}*) is smaller than said threshold, sink a current from said further intermediate node (C).

8. The voltage comparison circuit according to Claim 7, wherein said zero current detection circuit (40) comprises:
- a transistor (M8) corresponding to a further output of said first current mirror (M1, M2) or said second current mirror (M3, M4); and
- a circuit (M9, M10, M11, M12, R4) configured to sink said current from said further intermediate node (C), in response to determining that a current provided by said transistor (M8) is smaller than a given threshold.

9. The voltage comparison circuit according to Claim 8, wherein said circuit (M9, M10, M11, M12, R4) comprises:
- a fourth current mirror (M9, M10) having an input connected with a current bias source (R4) between said further terminal configured to receive a supply voltage *(VDD)* and said second terminal (102);
- a fifth current mirror (M11, M12) having an input connected with an output of said fourth current mirror (M9, M10) between said further terminal configured to receive a supply voltage *(VDD)* and said second terminal (102), and an output connected to said further intermediate node (C);
wherein said zero current detection circuit (40) is configured to disable said fourth current mirror (M9, M10) in response to determining that a current provided by said transistor (M8) is smaller than said given threshold.

10. The voltage comparison circuit according to Claim 9,
wherein said fourth current mirror (M9, M10) comprises:
- a seventh p-channel FET (M9) having a source connected to said further terminal configured to receive a supply voltage *(VDD),* a drain connected via said current bias source (R4) to said second terminal (102), and a gate connected to the drain of said seventh p-channel FET (M9);
- an eighth p-channel FET (M10) having a source connected to said further terminal configured to receive a supply voltage *(VDD),* and a gate connected to the gate of said seventh p-channel FET (M9);
wherein said fifth current mirror (M11, M12) comprises:
- a fourth n-channel FET (M11) having a source connected to said second terminal (102), a drain connected to a drain of said ninth p-channel FET (M10), and a gate connected to the drain of said fourth n-channel FET (M11);
- a fifth n-channel FET (M12) having a source connected to said second terminal (102), a drain connected to said further intermediate node (C), and a gate connected to the gate of said fourth n-channel FET (M11);
wherein said transistor (M8) is a ninth p-channel FET having a source connected to said further terminal configured to receive a supply voltage *(VDD)* and a drain connected to the gate of said seventh p-channel FET (M9).

11. The voltage comparison circuit according to any of the previous claims, wherein said voltage divider (RA, RB) comprises at least one switchable resistance (RB).

12. An integrated circuit comprising the voltage comparison circuit according to any of the previous claims.

13. The integrated circuit according to Claim 12, comprising a Power Management Unit configured to change operation as a function of said comparison signal (PG).

14. A method of operating a voltage comparison circuit according to any of the previous Claims 1 to 11, comprising:
- receiving the input voltage (*V_{IN}*) at the first terminal (100) and the second terminal (102),
- receiving the supply voltage *(VDD)* at the further terminal,
- generating the measurement signal (*V_{S}*) indicative of the input voltage *(V_{IN})* via the measurement circuit (20),
- applying the measurement signal (*V_{S}*) via said voltage clamp (M0) to the bases of the first npn bipolar transistor (Q1) and the second npn bipolar transistor (Q2),
- generating said comparison signal (PG) as a function of a first current (*I_{Q1}*) flowing through the collector of said first npn bipolar transistor (Q1) and a second current *(I_{Q2})* flowing through the collector of said second npn bipolar transistor (Q2) by:
- determining whether said first current (*I_{Q1}*) is greater than said second current *(I_{Q2}),*
- in response to determining that said first current (*I_{Q1}*) is greater than said second current (*I_{Q2}*), asserting said comparison signal (PG), and
- in response to determining that said first current (*I_{Q1}*) is smaller than said second current *(I_{Q2}),* de-asserting said comparison signal (PG).
